(19) Europäisches Patentamt
European Patent Office
Office européen des brevets

(11) **EP 3 872 980 B1**

(12) **EUROPEAN PATENT SPECIFICATION**

(45) Date of publication and mention
of the grant of the patent:
**05.04.2023 Bulletin 2023/14**

(21) Application number: **21157286.2**

(22) Date of filing: **16.02.2021**

(51) International Patent Classification (IPC):
***H02P 9/00*** *(2006.01)*

(52) Cooperative Patent Classification (CPC):
**H02P 9/00**

(54) **POWER BALANCE FUNCTION AGAINST INADVERTENT LOAD SHEDDING**

LEISTUNGSAUSGLEICHSFUNKTION GEGEN UNBEABSICHTIGTEN LASTABWURF

FONCTION D'ÉQUILIBRE DE PUISSANCE CONTRE LES DÉLESTAGES ACCIDENTELS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.02.2020 CN 202010098947**

(43) Date of publication of application:
**01.09.2021 Bulletin 2021/35**

(73) Proprietor: **Siemens Aktiengesellschaft
80333 München (DE)**

(72) Inventors:
• **MA, Yan**
**Nanjing 210000 (CN)**
• **GAO, Di Jun**
**Nanjing 210004 (CN)**
• **LI, Jun Hong**
**Nanjing 210000 (CN)**
• **LI, Xin**
**Nanjing 211100 (CN)**
• **ZHOU, Yan Ping**
**Nanjing 211100 (CN)**
• **CUI, Feng Xian**
**Nanjing 211100 (CN)**
• **CAO, Zhen**
**Nanjing 211100 (CN)**

(74) Representative: **Horn Kleimann Waitzhofer
Patentanwälte PartG mbB
Ganghoferstraße 29a
80339 München (DE)**

(56) References cited:
**EP-A1- 2 423 464      DE-A1-102012 211 719
JP-A- 2009 159 700**

## Description

Technical Field

The present invention relates to the technical of power engineering, and in particular relates to a generator load state detection method and device and a computer-readable medium.

Background Art

A generator is a machine which can convert energy in other forms into electric energy. In a power transmission system including a generator, the power receiving system serving as the load of the generator is connected to the generator with cables, the generator transmits the electric energy to the power receiving system through the cables, and the power receiving system utilizes or retransmits the received electric energy. The generator in the power transmission system has two different control modes: load control mode and speed control mode. The generator in load control mode is responsible for steadily outputting a power, and the generator in speed control mode is responsible for adjusting the output power according to the load.

For the generator running in load control mode, when a fault of the power receiving system causes an unexpected interruption of the generator load, the generator will still run in load control mode because the generator is unable to obtain a response to the interruption of load. However, since the load power output by the generator is reduced, the generator will increase the rotational speed, expecting to achieve preset target output power. In this case, the power and the rotational speed of the generator are both increased. When the rotational speed of the generator exceeds a preset speed threshold, the over-speed protection function is triggered and the power and the rotational speed of the generator are both reduced. After the rotational speed of the generator is so reduced that the over-speed protection function is terminated, the generator will increase the rotational speed, expecting to achieve the target output power. Then the rotational speed of the generator is alternately increased and reduced, causing generator oscillations. Thus, it can be seen that an unexpected load interruption of the generator will cause generator oscillations. Oscillations will cause damage to the mechanical structure of the generator. Therefore, it is necessary to detect the load state of the generator so that protective measures can be taken in time in the case of an unexpected load interruption of the generator.

JP 2009 159700 A discloses an output control device and control method of a generator, wherein it is determined whether a difference between a target generator output and a present generator output is within a dead zone width, which is a ratio to a generator rating, and when the determination result deviates from the dead zone width, and the target generator output is larger than the present generator output, a governor increase command is issued one time for only a time proportional to the difference, and control for increasing the generator outputs is repeated.

DE 10 2012 211 719 A1 discloses a bicycle comprising a control device having a memory with predefined route profiles and target powers assigned to them, wherein the control device is used to determine a differential power from the target power and the detected actual power, wherein a drive system is operating in motor mode or generator mode depending on the determined differential power.

EP 2 423 464 A1 discloses a method of controlling a turbine set having a turbine and a generator, the method comprising the steps of: providing a first signal indicative of a reduction in the actual output of the generator; generating a second signal indicative of a short circuit interruption in response to the first signal; resetting the second signal after a predetermined first period of time and blocking the second signal for a predetermined second period of time; braking and then accelerating the turbine in response to the second signal; generating a third signal indicating a load shedding of the turbine set after a predetermined third period of time in response to the first signal when the first signal is provided by the actual power of the generator decreasing to a predetermined negative value and the actual power of the generator becoming less than twice the internal demand and the difference between a target power and the actual power of the generator becoming greater than twice the internal demand of the turbine set; and load shedding on the turbine generator's own demand as a function of the third signal.

Summary of the Invention

The generator load state detection method and device and the computer-readable medium provided by the present invention for this reason can accurately detect whether the load of a generator is unexpectedly interrupted.

In a first aspect, the present invention provides a generator load state detection method as defined in claim 1.

In a first possible implementation mode, in combination with the first aspect, acquiring the load power of a target generator comprises:

acquiring the positive sequence voltage and the positive sequence current of the output end of the target generator;
using the following formula to calculate the load power according to the positive sequence voltage and the positive sequence current:

$$P = 3 \times \left[ Re(U_1) \cdot Re(I_1) + Im(U_1) \cdot Im(I_1) \right]$$

wherein, $P$ represents the load power, $U_1$ represents the positive sequence voltage, $I_1$ represents the positive sequence current, $Re(U_1)$ represents the real part of the positive sequence voltage, $Im(U_1)$ represents the imaginary part of the positive sequence voltage, $Re(I_1)$ represents the real part of the positive sequence current, and $Im(I_1)$ represents the imaginary part of the positive sequence current.

In a second possible implementation mode, in combination with the first aspect, determining the load state of the target generator according to the power imbalance value comprises:

acquiring the determination results of the following two conditions and determining that an unexpected interruption happens to the target generator if the determination results of the following two conditions are both Yes;
condition 1: determine whether the power imbalance value is greater than a power balance threshold;
condition 2: determine whether the target generator changes from a normal running state to a low load power state.

In a third possible implementation mode, in combination with the second possible implementation mode, condition 2 comprises:
determining whether the target generator changes from the normal running state to the low power state and whether the time the target generator maintains in the low power state exceeds a preset time threshold.

In a fourth possible implementation mode, in combination with the first aspect and any of the first possible implementation mode, the second possible implementation mode and the third possible implementation mode of the first aspect, after determining the load state of the target generator according to the power imbalance value, the method further comprises:

acquiring the determination results of the following conditions and determining whether to send indication information according to the acquired determination results, wherein the indication information is used to represent an unexpected load interruption of the target generator;
forbidding sending the indication information to an external device if at least one of the acquired determination results is Yes;
condition 3: determine whether a system oscillation happens to the system where the target generator is located;
condition 4: determine whether the signal acquisition function of the target generator is abnormal;
condition 5: determine whether a fault happens to the target generator.

In a fifth possible implementation mode, in combination with the fourth possible implementation mode, condition 5 comprises:
determining whether a negative sequence voltage or a zero sequence voltage happens to the output end of the target generator, and if Yes, determining that a fault happens to the target generator.

In a sixth possible implementation mode, in combination with the fourth possible implementation mode, condition 4 comprises:

determining whether a disconnection happens to at least one of the following circuits: voltage measuring circuit and current measuring circuit, wherein the voltage measuring circuit is used to determine the positive sequence voltage of the output end of the target generator, the current measuring circuit is used to determine the positive sequence current of the output end of the target generator, and the positive sequence voltage and the positive sequence current are used to determine the load power;
determining that the signal acquisition function of the target generator is abnormal if the determination result is Yes.

In a seventh possible implementation mode, in combination with the fourth possible implementation mode, the generator load state detection method further comprises:
sending the indication information if the determination results of conditions 3, 4 and 5 are all No.

[0016]    In a second aspect, the present invention provides a generator load state detection device as defined in claim 9.

In a first possible implementation mode, in combination with the second aspect, the load power acquisition module comprises:

an information acquisition unit, used to acquire the positive sequence voltage and the positive sequence current of the output end of the target generator;

a management and calculation unit, used to use the following formula to calculate the load power according to the positive sequence voltage and the positive sequence current acquired by the information acquisition unit;

$$P = 3 \times [Re(U_1) \cdot Re(I_1) + Im(U_1) \cdot Im(I_1)]$$

wherein, $P$ represents the load power, $U_1$ represents the positive sequence voltage, $I_1$ represents the positive sequence current, $Re(U_1)$ represents the real part of the positive sequence voltage, $Im(U_1)$ represents the imaginary part of the positive sequence voltage, $Re(I_1)$ represents the real part of the positive sequence current, and $Im(I_1)$ represents the imaginary part of the positive sequence current.

In a second possible implementation mode, in combination with the second aspect, the load state detection module is used to acquire the determination results of the following two conditions and determine that an unexpected interruption happens to the target generator if the determination results of the following two conditions are both Yes;

condition 1: determine whether the power imbalance value is greater than a power balance threshold;
condition 2: determine whether the target generator changes from a normal running state to a low load power state.

In a third possible implementation mode, in combination with the second aspect, the load state detection module is used to determine whether the target generator changes from the normal running state to the low power state and whether the time the target generator maintains in the low power state exceeds a preset time threshold when acquiring the determination result of condition 2.

In a fourth possible implementation mode, in combination with the second aspect and any of the first possible implementation mode, the second possible implementation mode and the third possible implementation mode of the second aspect, the generator load state detection device further comprises:

a condition determination module, used to acquire the determination results of the following conditions after the load state detection module determines the load state of the target generator according to the power imbalance value, and to determine whether to send indication information according to the acquired determination results, wherein the indication information is used to represent an unexpected load interruption of the target generator;
condition 3: determine whether a system oscillation happens to the system where the target generator is located;
condition 4: determine whether the signal acquisition function of the target generator is abnormal;
condition 5: determine whether a fault happens to the target generator; an information interception module, used to forbid the condition determination module to send the indication information to an external device if at least one of the determination results acquired by the condition determination module is Yes;

In a fifth possible implementation mode, in combination with the fourth possible implementation mode, the condition determination module is used to determine whether a negative sequence voltage or a zero sequence voltage happens to the output end of the target generator when acquiring the determination result of condition 5, and if Yes, determine that a fault happens to the target generator.

In a sixth possible implementation mode, in combination with the fourth possible implementation mode, the condition determination module is used to determine whether a disconnection happens to at least one of the following circuits: voltage measuring circuit and current measuring circuit when acquiring the determination result of condition 4, and to determine that the signal acquisition function of the target generator is abnormal if the determination result is Yes, wherein the voltage measuring circuit is used to determine the positive sequence voltage of the output end of the target generator, the current measuring circuit is used to determine the positive sequence current of the output end of the target generator, and the positive sequence voltage and the positive sequence current are used to determine the load power.

In a seventh possible implementation mode, in combination with the fourth implementation mode, the condition determination module is used to send the indication information when the acquired determination results of conditions 3, 4 and 5 are all No.

[0024]    In a third aspect, the embodiments of the present invention further provide another generator load state detection device, which comprises at least one memory and at least one processor, wherein

the at least one memory is used to store a machine-readable program;
the at least one processor is used to invoke the machine-readable program to execute the method provided by the first aspect or provided by any possible implementation mode of the first aspect.

In a fourth aspect, the embodiments of the present invention further provide a computer-readable medium. Computer instructions are stored in the computer-readable medium. When the computer instructions are invoked by a processor, the processor executes the method provided by the first aspect or any possible implementation mode of the first aspect.

From the above-mentioned technical solution, it can be seen that the load power is used to represent the actual output power of a target generator, the target output power is used to represent the power required by the target generator to output in load control mode, and the difference between the load power and the target output power is calculated as a power imbalance value after the load power and the target output power of the target generator are acquired. Since the load power of the target generator in the case of no unexpected load interruption of the generator is close to the target output power and the load power is greatly different from the target output power in the case of an unexpected load interruption of the generator, an unexpected load interruption of the target generator can be determined according to the power imbalance value. When an unexpected load interruption of the target generator is determined according to the power imbalance value, it is unnecessary to compare a plurality of parameter thresholds with acquired parameter values, avoiding an inaccurate load state detection of the target generator caused by inaccurate determinations of parameter thresholds. Thus, an unexpected load interruption of the target generator can be determined more accurately.

Brief Description of the Drawings

Fig. 1 is a flowchart of a generator load state detection method provided by one embodiment of the present invention.

Fig. 2 is a flowchart of a load power acquisition method provided by one embodiment of the present invention.

Fig. 3 is a flowchart of an indication information sending method provided by one embodiment of the present invention.

Fig. 4 shows the trend of the changes of the load power and the frequency of the generator after an unexpected load interruption in one embodiment of the present invention.

Fig. 5 shows the trend of the changes of the load power and the frequency of the generator in the case of no unexpected load interruption in one embodiment of the present invention.

Fig. 6 shows a generator load state detection device provided by one embodiment of the present invention.

Fig. 7 shows another generator load state detection device provided by one embodiment of the present invention.

Fig. 8 shows a further generator load state detection device provided by one embodiment of the present invention.

Fig. 9 shows a fourth generator load state detection device provided by one embodiment of the present invention.

Description of reference numerals in the drawings:

101: Acquire the load power of a target generator
102: Acquire the target output power of the target generator
103: Calculate the difference between the load power and the target output power as a power imbalance value
104: Determine the load state of the target generator according to the power imbalance value
201: Acquire the positive sequence voltage and the positive sequence current of the output end of the target generator
202: Calculate the load power of the target generator according to the positive sequence voltage and the positive sequence current
301: Acquire the determination results of conditions 3, 4 and 5 and determine whether to send indication information according to the determination results
302: Forbid sending the indication information
303: Send indication information to the external device
601: Load power acquisition module     602: Target power acquisition module     603: Parameter calculation module

(continued)

| | | |
|---|---|---|
| 604: Load state detection module | 605: Condition determination module | 606: Information interception module |
| 6011: Information acquisition unit | 6012: Management and calcu-lation unit | 607: Memory |
| 608: Processor | | |

Detailed Description of the Invention

As mentioned above, in order to prevent a mechanical structure damage caused by long-time oscillations of a generator, it is necessary to detect in time whether the load of the generator is unexpectedly interrupted. If an unexpected load interruption of the generator is determined by comparing the parameters such as output power, frequency, positive sequence voltage and negative sequence voltage and phase current with the corresponding parameter thresholds, it is necessary to determine the corresponding thresholds of the parameters. Since the factors such as type, load and working condition of different generators are different, it is hard to uniformly determine the thresholds of the parameters of different generators. Because of the individual differences and the large number of parameter thresholds of generators, it is hard to guarantee the accuracy of the parameter thresholds determined for each generator, and then it is hard to accurately detect an unexpected load interruption of a generator.

In the embodiments of the present invention, the load power is used to represent the actual output power of a target generator, and the target output power is used to represent the power required by the target generator to output in load control mode. After the load power and the target output power of the target generator are determined, the difference between the load power and the target output power is determined as a power imbalance value. The load power of the target generator in the case of no unexpected load interruption of the generator is close to the target output power and the load power is greatly different from the target output power in the case of an unexpected load interruption of the generator. Thus, an unexpected load interruption of the target generator can be determined according to the power imbalance value. Since the accurate load power and target output power can be obtained, it is unnecessary to determine a great number of parameter thresholds for comparisons. Thus, an unexpected load interruption of the target generator can accurately be detected according to the calculated power imbalance value.

The generator load state detection method and device provided by the embodiments of the present invention are described in detail below in combination with the drawings.

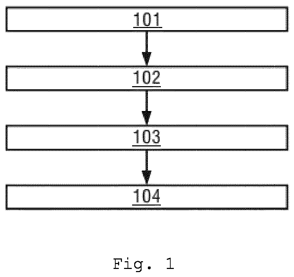

As shown in Fig. 1, the embodiments of the present invention provide a generator load state detection method and the method comprises the following steps:

Step 101: acquire the load power of a target generator, wherein the target generator is connected to a load with a set of cables, the target generator is in load control mode and the load power is used to represent the actual output power of the target generator;

Step 102: acquire the target output power of the target generator, wherein the target output power is used to represent the power required by the target generator to output in load control mode;

wherein, the target output power can be acquired from the control system of the power plant, specifically acquired through the transmission of information flows, and the target output power will be preset for the target generator in the control system, for example, preset by an operator;

Step 103: calculate the difference between the load power and the target output power as a power imbalance value;

Step 104: determine the load state of the target generator according to the power imbalance value.

In the embodiments of the present invention, the load power is used to represent the actual output power of a target generator, the target output power is used to represent the power required by the target generator to output in load control mode, and the difference between the load power and the target output power is calculated as a power imbalance value after the load power and the target output power of the target generator are acquired. Since the load power of the target generator in the case of no unexpected load interruption of the generator is close to the target output power and the load power is greatly different from the target output power in the case of an unexpected load interruption of the generator, an unexpected load interruption of the target generator can be determined according to the power imbalance value. When an unexpected load interruption of the target generator is determined according to the power imbalance value, it is unnecessary to compare a plurality of parameter thresholds with acquired parameter values, avoiding an inaccurate load state detection of the target generator caused by inaccurate determinations of parameter thresholds. Thus, an unexpected load interruption of the target generator can be determined more accurately.

In the embodiments of the present invention, the load states of the target generator include unexpected load interruption and no unexpected load interruption. An unexpected load interruption means that a load interruption happens before the target generator obtains the corresponding instruction or feedback, that is to say, the load already stops fetching electric energy, but the target generator does not know a load interruption and still produces electric energy in load control mode. No unexpected load interruption means that no load interruption of the target generator happens or the target generator already obtains the corresponding instruction or feedback before a load interruption happens, that is to say, the load normally fetches electric energy from the target generator or the target generator knows a load interruption and the load already stops fetching electric energy.

In the embodiments of the present invention, when the target generator is in load control mode, the target generator will steadily output a power according to the target output power under the control of the control system, and normally, the load power and the target output power of the target generator will not fluctuate greatly. Only in this case, an unexpected load interruption of the target generator can be determined according to the difference between the load power and the target output power. If the target generator is in speed control mode, the control system in the power plant will adjust the target output power of the generator in real time according to the load of the power system. Therefore, the generator in speed control mode is unable to determine an unexpected load interruption according to the difference between the load power and the target output power.

In the embodiments of the present invention, a single line is usually connected between the target generator and a load, and the target generator is connected to only one load, that is to say, only a set of cables transmitting electric energy is included between the target generator and the load. Normally, the target generator transmits electric energy to the load through the set of cables. When a fault of the set of cables causes a breaker trip, the target generator is unable to transmit electric energy to the load, or when any outgoing line of the set of cables is disconnected, the target generator is unable to transmit electric energy to the load, either. When the load is interrupted, the electric energy output by the target generator is unable to reach the load. If the generator is connected to a plurality of loads or the generator is connected to a load through a plurality of sets of cables, when one load is interrupted or a set of cables is disconnected, the generator can still transmit electric energy to other loads or transmits electric energy through other cables. In this case, a little difference exists between the load power and the target output power, and therefore, it is hard to detect whether a load of the generator is interrupted according to the power imbalance value.

Alternatively, on the basis of the generator load state detection method shown in Fig. 1, when the target output power of the target generator is acquired, the target output power is usually a fixed value or a slowly-changing value since the target generator is in load control mode. Therefore, the target output power can be acquired from the control system of the generator according to the preset data acquisition period. For the target generator applied in a power plant, the target output power of the target generator may be acquired from the control system of the power plant by a 4-20 mA transformer. In addition, the target output power of the target generator can be stored in advance, and when it is necessary to calculate the power imbalance value, the target output power stored in advance can directly be read, without any necessity of acquiring the target output power of the target generator from the control system of the generator in real time or periodically.

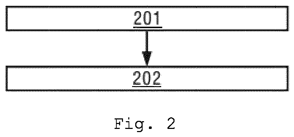

Alternatively, on the basis of the generator load state detection method shown in Fig. 1, the positive sequence voltage and positive sequence current of the output end of the target generator can be acquired, and then the load power of the target generator can be determined according to the acquired positive sequence voltage and positive sequence current. As shown in Fig. 2, the method of acquiring the load power of the target generator may comprise the following steps:

Step 201: acquire the positive sequence voltage and the positive sequence current of the output end of the target generator;

Step 202: use the following formula to calculate the load power of the target generator according to the positive sequence voltage and the positive sequence current;

$$P = 3 \times \left[ Re(U_1) \cdot Re(I_1) + Im(U_1) \cdot Im(I_1) \right]$$

wherein, $P$ represents the load power, $U_1$ represents the positive sequence voltage, $I_1$ represents the positive sequence current, $Re(U_1)$ represents the real part of the positive sequence voltage, $Im(U_1)$ represents the imaginary part of the positive sequence voltage, $Re(I_1)$ represents the real part of the positive sequence current, and $Im(I_1)$ represents the imaginary part of the positive sequence current.

In the embodiments of the present invention, the positive sequence voltage and positive sequence current of the output end of the target generator are determined, and then the load power of the target generator can be calculated according the real parts and imaginary parts of the positive sequence voltage and the positive sequence current. On the one hand, the calculation of the load power of the target generator only by determining the positive sequence voltage and the positive sequence current guarantees the convenience of acquiring the load power. On the other hand, the calculation of the load power of the target generator according to the positive sequence voltage and the positive sequence current guarantees the accuracy of the calculated load power and then guarantees the accuracy of the detection of the load state of the target generator.

In the embodiments of the present invention, the positive sequence voltage of the output end of the target generator may be obtained by calculating the voltages measured by a potential transformer (PT), and the positive sequence current of the output end of the target generator may be obtained by calculating the currents measured by a current transformer (CT). Of course, the positive sequence voltage and the positive sequence current of the output end of the target generator may be measured by other types of transformers or measuring circuits.

Alternatively, on the basis of the generator load state detection method shown in Fig. 1, step 104 of determining the load state of the target generator according to the power imbalance value may be realized in the following way:

Acquire the determination results of the following two conditions and determine that an unexpected interruption happens to the target generator if the determination results of the following two conditions are both Yes;
condition 1: determine whether the power imbalance value is greater than a power balance threshold;
condition 2: determine whether the target generator changes from a normal running state to a low load power state.

In the embodiments of the present invention, a specific example of determining the load state of the target generator according to the power imbalance value, namely, determining whether an unexpected interruption happens by determining the two conditions, is provided.

For condition 1: During the normal electric energy transmission of the target generator to the load, the target generator transmits electric energy according to the given target output power under the control of the control system of the generator, and the load power of the target generator is close to the target output power. In this case, the power imbalance value is small. When the load of the target generator is unexpectedly interrupted, the target output power of the target generator remains unchanged, while the load power of the target generator is reduced greatly. In this case, the power imbalance value is large. Thus, it can be seen that an unexpected load interruption of the target generator will lead to an increase of the power imbalance value. Therefore, a power balance threshold may be preset and the power imbalance value may be compared with the power balance threshold. An unexpected load interruption of the target generator possibly happens when the power imbalance value is greater than the power balance threshold, that is to say, the power imbalance value being greater than the power balance threshold is one of the basic conditions for an unexpected load interruption of the target generator.

Wherein, the power imbalance value is used to measure the difference between the target output power and the load power. Therefore, the absolute value of the difference between the target output power and the load power may be determined as a power imbalance value. The power imbalance value may be determined according to the rated power of the target generator, and may be 30% of the rated power, for example.

For condition 2: When the load of the target generator is unexpectedly interrupted, the load power of the target generator is reduced so greatly that the load power of the target generator is less than the corresponding threshold and the target generator changes from a normal running state to a low load power state. Here, the normal running state refers to a state in which the target generator runs normally. For example, a threshold may be preset and if the load power is greater than the threshold, it is considered that the target generator is in the normal running state. Details are omitted. A low load power state refers to a state in which the target generator runs at a low load power, that is to say, the load power of the target generator is less than a certain threshold. When the load of the target generator is unexpectedly interrupted, the load power of the target generator is reduced so greatly that the load power of the target generator is less than the corresponding threshold and the target generator changes to a low load power state.

An unexpected load interruption of the target generator will cause the target generator to change to the low load power state. In addition, a load fluctuation of the target generator or other reasons may also cause the target generator to change to the low load power state. However, the low load power state caused by a load fluctuation or other reasons is temporary, that is to say, after the load power of the target generator is temporarily less than the corresponding threshold, it will return to the normal level. However, the low load power state caused by an unexpected load interruption of the target generator is continuous, that is say, after the load of the target generator is unexpectedly interrupted, and the load power of the target generator will continuously be less than the corresponding threshold. Therefore, the low load power state caused by a load fluctuation and other reasons can be ruled out according to whether the time the target generator maintains in the low load power state is greater than a preset time threshold, and the accuracy of the detection of the load state of the target generator can be guaranteed. That is say, after the target generator runs from the normal running state to the low load power state and the low load power state is maintained for a period of time, it is determined that the target generator changes from the normal running state to the low load power state.

Alternatively, after the determination results of the above-mentioned two conditions are both Yes and the low load power state is maintained for a period of time, an unexpected load interruption can finally be determined. For example, after determining the power imbalance value is continuously greater than the power balance threshold, determine the determination result of condition 1 is Yes, or after determining the target generator changes from the normal running state to the low load power state and the time the target generator maintains in the low load power state is exceeds a preset time threshold, determine the result of condition 2 is Yes.

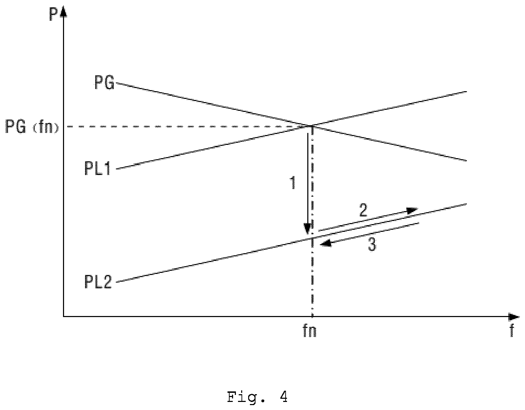

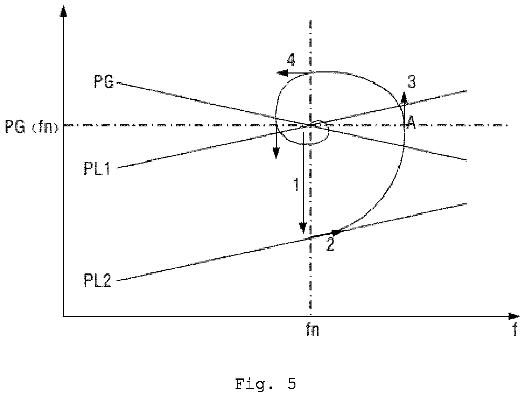

Figs. 4 and 5 show the trend of the changes of the load power and frequency of the target generator after an unexpected load interruption and the trend of the changes of the load power and frequency of the target generator in load control mode, respectively. The trend of the changes of the load power and frequency of the target generator after an unexpected load interruption and the trend of the changes of the load power and frequency of the target generator running normally in load control mode are described respectively below.

As shown in Fig. 4, after the load of the target generator is unexpectedly interrupted, the load power decreases from PL1 to PL2, as indicated by arrow 1; later, the load power increases according to the new power frequency characteristic curve (PL2) to expect to reach a new balance state (the intersection point of PL2 with PG is the new balance state point and PG represents the characteristic curve of the target output frequency), as indicated by arrow 2; after the rotational speed of the target generator exceeds the speed threshold, the over-speed control function takes effect, the rotational speed of the target generator is reduced, and the load power and frequency of the target generator are both reduced, as indicated by arrow 3; after the rotational speed of the target generator is reduced to the speed threshold for ending over-speed control, the target generator again increases the load power in load control mode, as indicated by arrow 2; thus the steps indicated by arrows 2 and 3 are alternately and cyclically performed, causing oscillations of the target generator.

As shown in Fig. 5, if the load of the target generator is not unexpectedly interrupted, after the load power decreases from PL1 to PL2 as indicated by arrow 1, the load power increases according to the new power frequency characteristic curve (PL2), as indicated by arrow 2, because the control system of the generator is unable to respond in time. When the generator in speed control mode in the power supply system reduces the load power because of too high a rated frequency, the target generator in load control mode will increase the load power. Since the output load power is still less than the target output power, the frequency of the target generator is continuously but very slowly increased, as indicated by arrow 3. When the load power of the target generator is equal to the target output power at point A, the frequency of the target generator exceeds the rated frequency. The generator in speed control mode in the power supply system will still reduce the output load power because of too high a rated frequency, and therefore, the target generator in load control mode will continue to increase the output load power. However, since the output load power is higher than the target output power, the frequency of the target generator starts to decrease, as indicated by arrow 4. Finally, the output load power of the target generator returns to PG (fn) and the frequency of the target generator returns to the rated frequency to satisfy the previous power balance state again.

According to the comparison between Figs. 4 and 5, after the load of the target generator is unexpectedly interrupted, the balance between the target output power and the load power of the target generator is broken and a great difference exists between the target output power and the load power; when the load of the target generator is not unexpectedly interrupted, a balance can eventually be maintained between the load power of the target generator in load control mode and the target output power, and the difference between the target output power and the load power is reduced to a small level in a short time.

Alternatively, after an unexpected load interruption of the target generator is determined, corresponding indication information will be sent to other components and the other components may perform corresponding operations after receiving the indication information, for example, send trip information to the switch of the target generator so that the switch is tripped. However, for the reason that the load fluctuates, the signal acquisition function of the generator is abnormal or the target generator itself is faulty, even if the determination results of conditions 1 and 2 are both Yes in some case, no unexpected load interruption actually happens. To avoid sending indication information wrongly, it is necessary to determine the following condition before sending indication information. If one of the determination results is Yes, sending the indication information to the external device is forbidden.

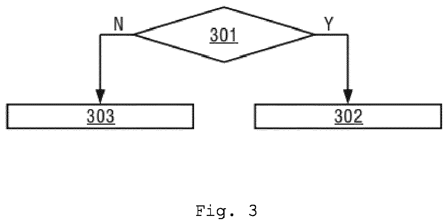

That is to say, as shown in Fig. 3, after determining an unexpected load interruption happens to the target generator, the method further comprises:

Step 301: acquire the determination results of the following conditions and determine whether to send information indicating that an unexpected load interruption happens to the target generator according to the determination results. If at least one of the determination results is Yes, go to step 302, and otherwise go to step 303.

condition 3: determine whether a system oscillation happens to the system where the target generator is located;
condition 4: determine whether the signal acquisition function of the target generator is abnormal;
condition 5: determine whether a fault happens to the target generator.

For condition 3: determine whether a system oscillation is detected. How to detect a system oscillation belongs to the prior art and is not described again here.

For condition 4: determine whether a fault happens to at least one of the following circuits: voltage measuring circuit and current measuring circuit, wherein the voltage measuring circuit is used to determine the positive sequence voltage of the output end of the target generator, the current measuring circuit is used to determine the positive sequence current of the output end of the target generator, and the positive sequence voltage and the positive sequence current are used to determine the load power;

determine that the signal acquisition function of the target generator is abnormal if the determination result is Yes.

If a fault happens to at least one of the voltage measuring circuit and the current measuring circuit, the calculated load power will be incorrect, and thus the accuracy of the detection of the load state of the target generator will be affected. Therefore, it is necessary to determine whether a fault happens to the voltage measuring circuit or current measuring circuit so as to avoid wrongly obtaining the detection result that the load of the target generator is unexpectedly interrupted.

For condition 5: determine whether a negative sequence voltage or a zero sequence voltage happens to the output end of the target generator, and if Yes, determine that a fault happens to the target generator. How to acquire the negative sequence voltage or zero sequence voltage of the output end of the target generator belongs to the prior art and is not described again here.

When the running state of the target generator is abnormal, the load power of the target generator may continuously be less than the corresponding power threshold, that is to say, the power imbalance value is greater than the power balance threshold and the time the target generator runs in the low load state is greater than the time threshold. Since the power imbalance value is determined according to the parameters acquired from the target generator, for example, according to the positive sequence voltage and positive sequence current acquired from the output end of the target generator, if the signal acquisition function of the target generator is abnormal, the acquired parameters used to determine the power imbalance value are inaccurate. Therefore, the power imbalance value determined according to the acquired parameters is also inaccurate, thus causing the acquired power imbalance value to be greater than the power balance threshold and the time the target generator runs in the low power state to be greater than the time threshold. However, the load power of the target generator is actually no less than the corresponding power threshold.

By detecting whether a system oscillation happens, whether the signal acquisition function of the target generator is abnormal and whether a fault happens to the target generator, the case that the determination results of conditions 1 and 2 are both Yes because of the abnormal running of the target generator itself can be ruled out, and thus the accuracy of the determination of an unexpected load interruption of the target generator according to the power imbalance value can be guaranteed. Namely, even if the results of conditions 1 and 2 are both Yes, if at least one of the determination results of conditions 3, 4 and 5 is No, sending indication information to the external device will be forbidden, and then no corresponding measure will be taken for the determined unexpected load interruption. That is to say, before determining an unexpected load interruption of the target generator, it is necessary to further determine conditions 3, 4 and 5. If the determination result of any of conditions 3, 4 and 5 is Yes, it can be determined that no unexpected load interruption actually happens to the target generator.

Step 302: Forbid sending indication information.

Step 303: Send indication information to the external device.

According to the method, the accuracy of the determination of an unexpected load interruption of the target generator can be improved and mis-operations can be avoided.

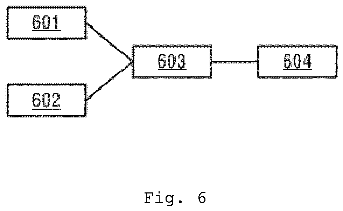

As shown in Fig. 6, the embodiments of the present invention provide a generator load state detection device, which comprises:

a load power acquisition module 601, used to acquire the load power of a target generator, wherein the target generator is connected to a load with a set of cables, the target generator is in load control mode and the load power is used to represent the actual output power of the target generator;

a target power acquisition module 602, used to acquire the target output power of the target generator, wherein the target output power is used to represent the power required by the target generator to output in load control mode;

a parameter calculation module 603, used to calculate the difference between the load power acquired by the load power acquisition module 601 and the target output power acquired by the target power acquisition module 602 as a power imbalance value;

a load state detection module 604, used to determine the load state of the target generator according to the power imbalance value calculated by the parameter calculation module 603.

In the embodiments of the present invention, the load power acquisition module 601 may be used to perform step 101 in the embodiment of the above-mentioned method, the target power acquisition module 602 may be used to perform step 102 in the embodiment of the above-mentioned method, the parameter calculation module 603 may be used to perform step 103 in the embodiment of the above-mentioned method, and the load state detection module 604 may be used to perform step 104 in the embodiment of the above-mentioned method.

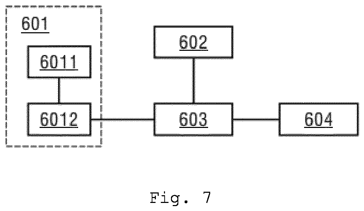

Alternatively, on the basis of the generator load state detection device shown in Fig. 6, as shown in Fig. 7, the load power acquisition module 601 comprises:

an information acquisition unit 6011, used to acquire the positive sequence voltage and the positive sequence current of the output end of the target generator;

a management and calculation unit 6012, used to use the following formula to calculate the load power according to the positive sequence voltage and the positive sequence current acquired by the information acquisition unit 6011;

$$P = 3 \times \left[ Re(U_1) \cdot Re(I_1) + Im(U_1) \cdot Im(I_1) \right]$$

wherein, $P$ represents the load power, $U_1$ represents the positive sequence voltage, $I_1$ represents the positive sequence current, $Re(U_1)$ represents the real part of the positive sequence voltage, $Im(U_1)$ represents the imaginary part of the positive sequence voltage, $Re(I_1)$ represents the real part of the positive sequence current, and $Im(I_1)$ represents the imaginary part of the positive sequence current.

In the embodiments of the present invention, the information acquisition unit 6011 may be used to perform step 201 in the embodiment of the above-mentioned method, and the management and calculation unit 6012 may be used to perform step 202 in the embodiment of the above-mentioned method.

Alternatively, on the basis of the generator load state detection device shown in Fig. 6, the load state detection module 604 is used to acquire the determination results of the following two conditions and determine that an unexpected interruption happens to the target generator if the determination results of the following two conditions are both Yes;

condition 1: determine whether the power imbalance value is greater than a power balance threshold;

condition 2: determine whether the target generator changes from a normal running state to a low load power state.

Alternatively, on the basis of the generator load state detection device shown in Fig. 6, the load state detection module 604 is used to determine whether the target generator changes from the normal running state to the low power state and whether the time the target generator maintains in the low power state exceeds a preset time threshold when acquiring the determination result of condition 2.

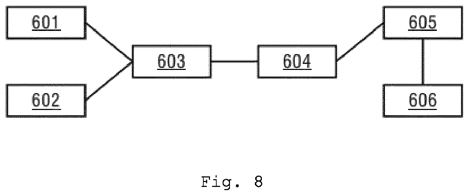

Alternatively, on the basis of the generator load state detection device shown in Fig. 6, as shown in Fig. 8, the generator load state detection device further comprises: a condition determination module 605, used to acquire the determination results of the following conditions after the load state detection module 604 determines the load state of the target generator according to the power imbalance value, and determine whether to send indication information according to the acquired determination results, wherein the indication information is used to represent an unexpected load interruption of the target generator;

condition 3: determine whether a system oscillation happens to the system where the target generator is located;

condition 4: determine whether the signal acquisition function of the target generator is abnormal;

condition 5: determine whether a fault happens to the target generator;

an information interception module 606, used to forbid the condition determination module 605 to send the indication information to an external device if at least one of the determination results acquired by the condition determination module 605 is Yes.

In the embodiments of the present invention, the condition determination module 605 may be used to perform steps 301 and 303 in the embodiments of the above-mentioned method, and the information interception module 606 may be used to perform step 302 in the embodiment of the above-mentioned method.

Alternatively, on the basis of the generator load state detection device shown in Fig. 8, the condition determination module 605 is used to determine whether a negative sequence voltage or a zero sequence voltage happens to the output end of the target generator when acquiring the determination result of condition 5, and determine that a fault happens to the target generator if the determination result is Yes.

Alternatively, on the basis of the generator load state detection device shown in Fig. 8, the condition determination module 605 is used to determine whether a disconnection happens to at least one of the following circuits: voltage measuring circuit and current measuring circuit when acquiring the determination result of condition 4, and determine that the signal acquisition function of the target generator is abnormal if the termination result is Yes, wherein the voltage measuring circuit is used to determine the positive sequence voltage of the output end of the target generator, the current measuring circuit is used to determine the positive sequence current of the output end of the target generator, and the positive sequence voltage and the positive sequence current are used to determine the load power.

Alternatively, on the basis of the generator load state detection device shown in Fig. 8, the condition determination module 605 is used to send indication information when the acquired determination results of conditions 3, 4 and 5 are all No.

**[0074]** It should be noted that the generator load state detection device provided in the embodiments of the present invention and the generator load state detection method provided in the above-mentioned embodiments are both based on the conception of one invention. For specific interactions between the modules and units in the generator load state detection device, refer to the description in the above-mentioned method embodiments. These interactions will not be described again here.

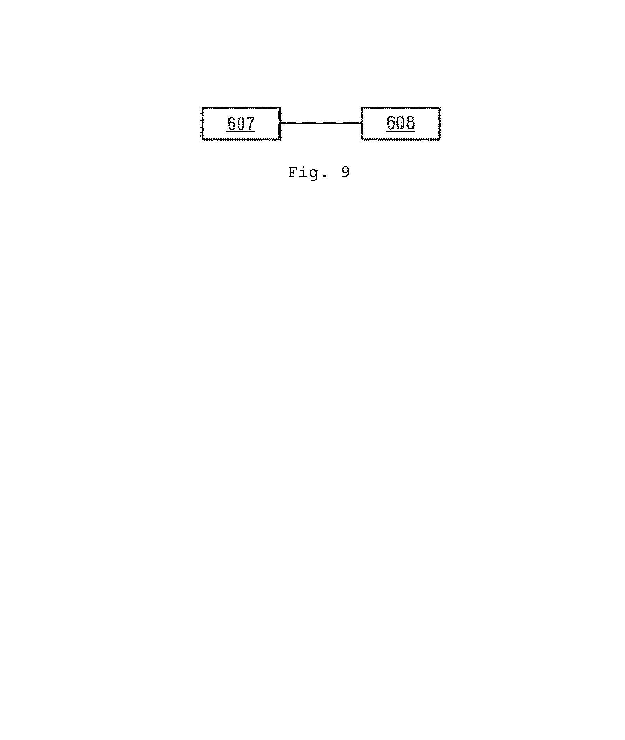

As shown in Fig. 9, the embodiments of the present invention provide a generator load state detection device, which comprises at least one memory 607 and at least one processor 608, wherein

the at least one storage 607 is used to store a machine-readable program, and
the at least one processor 608 is used to invoke machine-readable program stored in the at least one memory 607
to perform the generator load state detection method provided in the above-mentioned embodiments.

The present invention further provides a computer-readable medium, which stores instructions used to allow a machine to execute the generator load state detection method described in this document. Specifically, a system or device equipped with a storage medium can be provided. Software program codes which can realize the function in any of above-mentioned embodiments are stored in the storage medium and the computer (or CPU or MPU) of the system or device can read and execute the program codes stored in the storage medium.

In this case, program codes read from the storage medium themselves can realize the function in any of the above-mentioned embodiments. Therefore, program codes and the storage medium where program codes are stored constitute a part of the present invention.

Embodiments of the storage medium used to provide program codes include a floppy disk, hard disk, magneto-optical disk, compact disk (for example, compact disk read-only memory (CD-ROM)), compact disk - recordable (CD-R), compact disk - rewritable (CD-RW), digital video disk - read only memory (DVD-ROM), digital versatile disk - random access memory (DVD-RAM), digital versatile disk plus rewritable (DVD+RW), magnetic tape, non-volatile memory card, and read-only memory (ROM). Alternatively, the program codes may be downloaded from the server computer over a communication network.

In addition, it should clearly be understood that the function of any of the above-mentioned embodiments can be realized not only by executing the program codes read out by a computer, but also by letting the operating system running on the computer complete a part or all of practical operations through program code based instructions.

In addition, it should be understood that the program codes read out of a storage medium are written into the memory in the expansion board in a computer or are written into a memory in an expansion module connected to the computer, and then the program code based instructions let the CPU installed on the expansion board or expansion module execute a part or all of practical operations to realize the function of any of the above-mentioned embodiments.

It should be noted that not all steps or modules in the above-mentioned flowcharts and system structure diagrams are required, and some steps or modules can be omitted, depending on the actual requirements. The execution sequence of the steps is not fixed and may be adjusted as required. The system structures described in the above-mentioned embodiments can be physical structures or logical structures. That is to say, some modules may be realized by a physical entity, or some modules may be realized by a plurality of physical entities or may jointly be realized by some components in a plurality of self-contained devices.

In the above-mentioned embodiments, hardware modules can mechanically or electrically be realized. For example, a hardware module can comprise a permanent dedicated circuit or logic (for example, special processor, FPGA, or ASIC) to complete the corresponding operations. A hardware module can further comprise a programmable logic or circuit (for example, a general processor or other programmable processor) and can complete the corresponding operations through temporary software setting. The specific implementation mode (mechanical mode, or dedicated permanent circuit, or circuit which is temporarily set) can be determined on the basis of consideration of cost and time.

The present invention is revealed and described in detail above in combination with the drawings and preferred embodiments.

**Claims**

1. A generator load state detection method, wherein the method comprises:

acquiring (101) the load power of a target generator, wherein the target generator is connected to a load with a set of cables, the target generator is in load control mode and the load power is used to represent the actual output power of the target generator;
acquiring (102) the target output power of the target generator, wherein the target output power is used to represent the power required by the target generator to output in load control mode;
calculating (103) the difference between the load power and the target output power as a power imbalance value;
**characterised by**
determining (104) if an unexpected load interruption of the target generator happens according to the power imbalance value.

2. The method as claimed in claim 1, wherein acquiring the load power of a target generator comprises:

acquiring (201) the positive sequence voltage and the positive sequence current of the output end of the target generator;
using the following formula to calculate (202) the load power according to the positive sequence voltage and the positive sequence current:

$$P = 3 \times [Re(U_1) \cdot Re(I_1) + Im(U_1) \cdot Im(I_1)]$$

wherein, $P$ represents the load power, $U_1$ represents the positive sequence voltage, $I_1$ represents the positive sequence current, $Re(U_1)$ represents the real part of the positive sequence voltage, $Im(U_1)$ represents the imaginary part of the positive sequence voltage, $Re(I_1)$ represents the real part of the positive sequence current, and $Im(I_1)$ represents the imaginary part of the positive sequence current.

3. The method as claimed in claim 1, wherein determining the load state of the target generator according to the power imbalance value comprises:

acquiring the determination results of the following two conditions and determining that the unexpected interruption happens to the target generator if the determination results of the following two conditions are both Yes;
condition 1: determine whether the power imbalance value is greater than a power balance threshold;
condition 2: determine whether the target generator changes from a normal running state to a low load power state.

4. The method as claimed in claim 3, wherein condition 2 comprises:
determining whether the target generator changes from the normal running state to the low power state and whether the time the target generator maintains in the low power state exceeds a preset time threshold.

5. The method as claimed in any of claims 1 to 4, wherein after determining the load state of the target generator according to the power imbalance value, the method further comprises:

acquiring (301) the determination results of the following conditions and determining whether to send indication information according to the acquired determination results, wherein the indication information is used to represent the unexpected load interruption of the target generator;
forbidding (302) sending the indication information to an external device if at least one of the acquired determination results is Yes;
condition 3: determine whether a system oscillation happens to the system where the target generator is located;
condition 4: determine whether the signal acquisition function of the target generator is abnormal;
condition 5: determine whether a fault happens to the target generator.

6. The method as claimed in claim 5, wherein condition 5 comprises:
determining whether a negative sequence voltage or a zero sequence voltage happens to the output end of the target generator, and if Yes, determining that a fault happens to the target generator.

7. The method as claimed in claim 5 or 6, wherein condition 4 comprises:
determining whether a disconnection happens to at least one of the following circuits:

voltage measuring circuit and current measuring circuit, wherein the voltage measuring circuit is used to determine the positive sequence voltage of the output end of the target generator, the current measuring circuit is used to determine the positive sequence current of the output end of the target generator, and the positive sequence voltage and the positive sequence current are used to determine the load power;

determining that the signal acquisition function of the target generator is abnormal if the determination result is Yes.

**8.** The method as claimed in any one of claims 5-7, wherein the method further comprises:

sending the indication information if the determination results of conditions 3, 4 and 5 are all No.

**9.** A generator load state detection device, in particular implemented to carry out the method of any one of claims 1-8, wherein the device comprises:

a load power acquisition module (601), used to acquire (101) the load power of a target generator, wherein the target generator is connected to a load with a set of cables, the target generator is in load control mode and the load power is used to represent the actual output power of the target generator;

a target power acquisition module (602), used to acquire (102) the target output power of the target generator, wherein the target output power is used to represent the power required by the target generator to output in load control mode;

a parameter calculation module (603), used to calculate (103) the difference between the load power acquired by the load power acquisition module (601) and the target output power acquired by the target power acquisition module (602) as a power imbalance value;

**characterised by**

a load state detection module (604), used to determine (104) if an unexpected load interruption of the target generator happens according to the power imbalance value calculated by the parameter calculation module (603).

**10.** The device as claimed in claim 9, wherein the load power acquisition module (601) comprises:

an information acquisition unit (6011), used to acquire (201) the positive sequence voltage and the positive sequence current of the output end of the target generator;

a management and calculation unit (6012), used to use the following formula to calculate (202) the load power according to the positive sequence voltage and the positive sequence current acquired by the information acquisition unit (6011);

$$P = 3 \times \left[ Re(U_1) \cdot Re(I_1) + Im(U_1) \cdot Im(I_1) \right]$$

wherein, $P$ represents the load power, $U_1$ represents the positive sequence voltage, $I_1$ represents the positive sequence current, $Re(U_1)$ represents the real part of the positive sequence voltage, $Im(U_1)$ represents the imaginary part of the positive sequence voltage, $Re(I_1)$ represents the real part of the positive sequence current, and $Im(I_1)$ represents the imaginary part of the positive sequence current.

**11.** The device as claimed in claim 9 or 10, wherein

the load state detection module (604) is used to acquire the determination results of the following two conditions and determine that the unexpected interruption happens to the target generator if the determination results of the following two conditions are both Yes;

condition 1: determine whether the power imbalance value is greater than a power balance threshold;

condition 2: determine whether the target generator changes from a normal running state to a low load power state.

**12.** The device as claimed in any one of claims 9 - 11, wherein

the load state detection module (604) is used to determine whether the target generator changes from the normal running state to the low power state and whether the time the target generator maintains in the low power state exceeds a preset time threshold when acquiring the determination result of condition 2.

**13.** The device as claimed in any of claims 9 to 12, wherein the device further comprises:

a condition determination module (605), used to acquire (301) the determination results of the following conditions after the load state detection module (604) determines the load state of the target generator according to the power imbalance value, and to determine whether to send indication information according to the acquired determination results, wherein the indication information is used to represent the unexpected load interruption of the target generator;

condition 3: determine whether a system oscillation happens to the system where the target generator is located;

condition 4: determine whether the signal acquisition function of the target generator is abnormal;

condition 5: determine whether a fault happens to the target generator;

an information interception module (606), used to forbid (302) the condition determination module (605) to send the indication information to an external device if at least one of the determination results acquired by the condition determination module (605) is Yes;

the condition determination module (605) being used to determine whether a negative sequence voltage or a zero sequence voltage happens to the output end of the target generator when acquiring the determination result of condition 5, and if Yes, determine that a fault happens to the target generator;

the condition determination module (605) being used to determine whether a disconnection happens to at least one of the following circuits: voltage measuring circuit and current measuring circuit when acquiring the determination result of condition 4, and determine that the signal acquisition function of the target generator is abnormal if the determination result is Yes, wherein the voltage measuring circuit is used to determine the positive sequence voltage of the output end of the target generator, the current measuring circuit is used to determine the positive sequence current of the output end of the target generator, and the positive sequence voltage and the positive sequence current are used to determine the load power;

the condition determination module (605) being used to send the indication information when the acquired determination results of conditions 3, 4 and 5 are all No.

14. A generator load state detection device, wherein the device comprises at least one memory (607) and at least one processor (608);

the at least one memory (607) being used to store a machine-readable program; the at least one processor (608) being used to invoke the machine-readable program to execute the method as claimed in any of claims 1 to 8.

15. A computer-readable medium, wherein computer instructions are stored in the computer-readable medium and a processor executes the method as claimed in any one of claims 1-8 when the computer instructions are executed by the processor.

**Patentansprüche**

1. Verfahren zur Erkennung eines Generatorlastzustands, wobei das Verfahren umfasst:

Erfassen (101) der Lastleistung eines Zielgenerators, wobei der Zielgenerator mit einer Last mit einem Satz von Kabeln verbunden ist, der Zielgenerator in einem Laststeuermodus ist, und die Lastleistung zum Darstellen der tatsächlichen Ausgangsleistung des Zielgenerators verwendet wird;

Erfassen (102) der Zielausgangsleistung des Zielgenerators, wobei die Zielausgangsleistung zum Darstellen der Leistung verwendet wird, die vom Zielgenerator zum Ausgeben im Laststeuermodus benötigt wird;

Berechnen (103) der Differenz zwischen der Lastleistung und der Zielausgangsleistung als Leistungsunsymmetriewert;

**gekennzeichnet durch**

Bestimmen (104), ob eine unerwartete Lastunterbrechung des Zielgenerators auftritt, gemäß dem Leistungsunsymmetriewert.

2. Verfahren nach Anspruch 1, wobei das Erfassen der Lastleistung eines Zielgenerators umfasst:

Erfassen (201) der mitläufigen Spannung und des mitläufigen Stroms des Ausgangsendes des Zielgenerators;

Verwenden der folgenden Formel zum Berechnen (202) der Lastleistung gemäß der mitläufigen Spannung und dem mitläufigen Strom:

$$P = 3 \times [Re(U_1) \cdot Re(I_1) + Im(U_1) \cdot Im(I_1)]$$

wobei $P$ die Lastleistung darstellt, $U_1$ die mitläufige Spannung darstellt, $I_1$ den mitläufigen Strom darstellt, $Re(U_1)$

den reellen Teil der mitläufigen Spannung darstellt, $Im(U_1)$ den imaginären Teil der mitläufigen Spannung darstellt, $Re(I_1)$ den reellen Teil des mitläufigen Stroms darstellt, und $Im(I_1)$ den imaginären Teil des mitläufigen Stroms darstellt.

3. Verfahren nach Anspruch 1, wobei das Bestimmen des Lastzustands des Zielgenerators gemäß dem Leistungsunsymmetriewert umfasst:
Erfassen der Bestimmungsergebnisse der folgenden zwei Bedingungen und Bestimmen, dass die unerwartete Unterbrechung am Zielgenerator auftritt, falls die Bestimmungsergebnisse der folgenden zwei Bedingungen jeweils Ja sind:

Bedingung 1: Bestimmen, ob der Leistungsunsymmetriewert über einer Leistungsausgleichsschwelle liegt;
Bedingung 2: Bestimmen, ob der Zielgenerator von einem Normalbetriebszustand in einen Schwachlastleistungszustand wechselt.

4. Verfahren nach Anspruch 3, wobei Bedingung 2 umfasst:
Bestimmen, ob der Zielgenerator vom Normalbetriebszustand in den Schwachlastleistungszustand wechselt und ob die Zeit, die der Zielgenerator im Schwachlastleistungszustand bleibt, eine voreingestellte Zeitschwelle überschreitet.

5. Verfahren nach einem der Ansprüche 1 bis 4, wobei das Verfahren nach dem Bestimmen des Lastzustands des Zielgenerators gemäß dem Leistungsunsymmetriewert ferner umfasst:

Erfassen (301) der Bestimmungsergebnisse der folgenden Bedingungen und Bestimmen gemäß den erfassten Bestimmungsergebnissen, ob Anzeigeinformationen gesendet werden sollen, wobei die Anzeigeinformationen zum Darstellen der unerwarteten Lastunterbrechung des Zielgenerators verwendet werden;
Verbieten (302) des Sendens der Anzeigeinformationen an eine externe Vorrichtung, falls mindestens eines der erfassten Bestimmungsergebnisse Ja ist;
Bedingung 3: Bestimmen, ob an dem System, in dem sich der Zielgenerator befindet, eine Systemschwingung auftritt;
Bedingung 4: Bestimmen, ob die Signalerfassungsfunktion des Zielgenerators anormal ist;
Bedingung 5: Bestimmen, ob ein Fehler am Zielgenerator auftritt.

6. Verfahren nach Anspruch 5, wobei Bedingung 5 umfasst:
Bestimmen, ob eine gegenläufige Spannung oder eine Nullspannung am Ausgangsende des Zielgenerators auftritt, und, falls Ja, Bestimmen, dass ein Fehler am Zielgenerator auftritt.

7. Verfahren nach Anspruch 5 oder 6, wobei Bedingung 4 umfasst:
Bestimmen, ob eine Trennung an mindestens einer der folgenden Schaltungen auftritt:

Spannungsmessungsschaltung und Strommessungsschaltung, wobei die Spannungsmessungsschaltung zum Bestimmen der mitläufigen Spannung des Ausgangsendes des Zielgenerators verwendet wird, die Strommessungsschaltung zum Bestimmen des mitläufigen Stroms des Ausgangsendes des Zielgenerators verwendet wird, und die mitläufige Spannung und der mitläufige Spannung zum Bestimmen der Lastleistung verwendet werden;
Bestimmen, dass die Signalerfassungsfunktion des Zielgenerator anormal ist, falls das Bestimmungsergebnis Ja ist.

8. Verfahren nach einem der Ansprüche 5 bis 7, wobei das Verfahren ferner umfasst:
Senden der Anzeigeinformationen, falls die Bestimmungsergebnisse von Bedingung 3, 4 und 5 allesamt Nein sind.

9. Vorrichtung zur Erkennung eines Generatorlastzustands, die insbesondere zum Durchführen des Verfahrens nach einem der Ansprüche 1 bis 8 implementiert wird, wobei die Vorrichtung umfasst:

ein Lastleistungserfassungsmodul (610), das zum Erfassen (101) der Lastleistung eines Zielgenerators verwendet wird, wobei der Zielgenerator mit einer Last mit einem Satz von Kabeln verbunden ist, der Zielgenerator in einem Laststeuermodus ist, und die Lastleistung zum Darstellen der tatsächlichen Ausgangsleistung des Zielgenerators verwendet wird;
ein Zielleistungserfassungsmodul (602), das zum Erfassen (102) der Zielausgangsleistung des Zielgenerators verwendet wird, wobei die Zielausgangsleistung zum Darstellen der Leistung verwendet wird, die vom Zielgenerator zum Ausgeben im Laststeuermodus benötigt wird;
ein Parameterberechnungsmodul (603), das zum Berechnen (103) der Differenz zwischen der vom Lastleistungserfassungsmodul (601) erfassten Lastleistung und der vom Zielleistungserfassungsmodul (602) erfassten Zielausgangsleistung als Leistungsunsymmetriewert verwendet wird;
**gekennzeichnet durch**
ein Lastzustandserkennungsmodul (604), das verwendet wird, um gemäß dem vom Parameterberechnungsmodul (603) berechneten Leistungsunsymmetriewert zu bestimmen, ob eine unerwartete Lastunterbrechung des Zielgenerators auftritt.

10. Vorrichtung nach Anspruch 9, wobei das Lastleistungserfassungsmodul (601) umfasst:

eine Informationserfassungseinheit (6011), die zum Erfassen (201) der mitläufigen Spannung und des mitläufigen Stroms des Ausgangsendes des Zielgenerators verwendet wird;
eine Verwaltungs- und Berechnungseinheit (6012), die verwendet wird, um die folgende Formel zum Berechnen (202) der Lastleistung gemäß der mitläufigen Spannung und dem mitläufigen Strom zu verwenden, die von der Informationserfassungseinheit (6011) erfasst werden;

$$P = 3 \text{ x } [Re(U_1)\cdot Re(I_1) + Im(U_1)\cdot Im(I_1)]$$

wobei $P$ die Lastleistung darstellt, $U_1$ die mitläufige Spannung darstellt, $I_1$ den mitläufigen Strom darstellt, $Re(U_1)$ den reellen Teil der mitläufigen Spannung darstellt, $Im(U_1)$ den imaginären Teil der mitläufigen Spannung darstellt, $Re(I_1)$ den reellen Teil des mitläufigen Stroms darstellt, und $Im(I_1)$ den imaginären Teil des mitläufigen Stroms darstellt.

11. Vorrichtung nach Anspruch 9 oder 10, wobei
das Lastzustandserkennungsmodul (604) zum Erfassen der Bestimmungsergebnisse der folgenden zwei Bedingungen und Bestimmen verwendet wird, dass die unerwartete Unterbrechung am Zielgenerator auftritt, falls die Bestimmungsergebnisse der folgenden zwei Bedingungen jeweils Ja sind:

Bedingung 1: Bestimmen, ob der Leistungsunsymmetriewert über einer Leistungsausgleichsschwelle liegt;
Bedingung 2: Bestimmen, ob der Zielgenerator von einem Normalbetriebszustand in einen Schwachlastleistungszustand wechselt.

12. Vorrichtung nach einem der Ansprüche 9 bis 11, wobei
wobei das Lastzustandserkennungsmodul (604) verwendet wird, um zu bestimmen, ob der Zielgenerator vom Normalbetriebszustand in den Schwachlastleistungszustand wechselt und ob die Zeit, die der Zielgenerator im Schwachlastleistungszustand bleibt, eine voreingestellte Zeitschwelle überschreitet.

13. Vorrichtung nach einem der Ansprüche 9 bis 12, wobei die Vorrichtung ferner umfasst:

ein Bedingungsbestimmungsmodul (605), das verwendet wird, um nach dem Bestimmen des Lastzustands des Zielgenerators gemäß dem Leistungsunsymmetriewert durch das Lastzustandserkennungsmodul (604) die Bestimmungsergebnisse der folgenden Bedingungen zu erfassen und gemäß den erfassten Bestimmungsergebnissen zu bestimmen, ob Anzeigeinformationen gesendet werden sollen, wobei die Anzeigeinformationen um Darstellen der unerwarteten Lastunterbrechung des Zielgenerators verwendet werden;
Bedingung 3: Bestimmen, ob an dem System, in dem sich der Zielgenerator befindet, eine Systemschwingung auftritt;
Bedingung 4: Bestimmen, ob die Signalerfassungsfunktion des Zielgenerators anormal ist;
Bedingung 5: Bestimmen, ob ein Fehler am Zielgenerator auftritt;
ein Informationsabfangmodul (606), das verwendet wird, um dem Bedingungsbestimmungsmodul (605) zu verbieten (302), die Anzeigeinformationen an eine externe Vorrichtung zu senden, falls mindestens eines der vom Bedingungsbestimmungsmodul (605) erfassten Bestimmungsergebnisse Ja ist;
wobei das Bedingungsbestimmungsmodul (605) verwendet wird, um beim Erfassen des Bestimmungsergebnisses von Bedingung 5 zu bestimmen, ob eine gegenläufige Spannung oder eine Nullspannung am Ausgangsende des Zielgenerators auftritt, und, falls Ja, zu bestimmen, dass ein Fehler am Zielgenerator auftritt;
das Bedingungsbestimmungsmodul (605) verwendet wird, um zu bestimmen, ob eine Trennung an mindestens einer der folgenden Schaltungen auftritt: Spannungsmessungsschaltung und Strommessungsschaltung beim Erfassen des Bestimmungsergebnisses von Bedingung 4, und zu bestimmen, dass die Signalerfassungsfunktion des Zielgenerators anormal ist, falls das Bestimmungsergebnis Ja ist, wobei die Spannungsmessungsschaltung zum Bestimmen der mitläufigen Spannung des Ausgangsendes des Zielgenerators verwendet wird, die Strommessungsschaltung zum Bestimmen des mitläufigen Stroms des Ausgangsendes des Zielgenerators verwendet wird, und die mitläufige Spannung und der mitläufige Spannung zum Bestimmen der Lastleistung verwendet werden;

das Bedingungsbestimmungsmodul (605) zum Senden der Anzeigeinformationen verwendet wird, wenn die erfassten Bestimmungsergebnisse von Bedingung 3, 4 und 5 allesamt Nein sind.

14. Vorrichtung zur Erkennung eines Generatorlastzustands, wobei die Vorrichtung mindestens einen Speicher (607) und mindestens einen Prozessor (608) umfasst;

der mindestens eine Speicher (607) zum Speichern eines maschinenlesbaren Programms verwendet wird; der mindestens eine Prozessor (608) verwendet wird, um das maschinenlesbare Programm zum Ausführen des Verfahrens nach einem der Ansprüche 1 bis 8 aufzurufen.

15. Computerlesbares Medium, wobei Computeranweisungen im computerlesbaren Medium gespeichert sind und ein Prozessor das Verfahren nach einem der Ansprüche 1 bis 8 ausführt, wenn die Computeranweisungen vom Prozessor ausgeführt werden.

## Revendications

1. Procédé de détection d'état de charge de générateur, le procédé comprenant :

l'acquisition (101) de la puissance de charge d'un générateur cible, dans lequel le générateur cible est connecté à une charge avec un ensemble de câbles, le générateur cible est en mode de régulation de charge et la puissance de charge est utilisée pour représenter la puissance de sortie réelle du générateur cible ;

l'acquisition (102) de la puissance de sortie cible du générateur cible, dans lequel la puissance de sortie cible est utilisée pour représenter la puissance requise par le générateur cible afin de produire une sortie en mode de régulation de charge ;

le calcul (103) de la différence entre la puissance de charge et la puissance de sortie cible en tant que valeur de déséquilibre de puissance ;

**caractérisé par**

la détermination (104) qu'une interruption de charge inattendue du générateur cible se produit ou non en fonction de la valeur de déséquilibre de puissance.

2. Procédé selon la revendication 1, dans lequel l'acquisition de la puissance de charge d'un générateur cible comprend :

l'acquisition (201) de la tension de séquence positive et du courant de séquence positif de l'extrémité de sortie du générateur cible ;

l'utilisation de la formule suivante pour calculer (202) la puissance de charge en fonction de la tension de séquence positive et du courant de séquence positif :

$$P = 3 \text{ x } [Re(U_1).Re(I_1) + Im(U_1).Im(I_1)]$$

dans lequel, $P$ représente la puissance de charge, $U_1$ représente la tension de séquence positive, $I_1$ représente le courant de séquence positif, $Re(U_1)$ représente la partie réelle de la tension de séquence positive, $Im(U_1)$ représente la partie imaginaire de la tension de séquence positive, $Re(I_1)$ représente la partie réelle du courant de séquence positif, et $Im(I_1)$ représente la partie imaginaire du courant de séquence positif.

3. Procédé selon la revendication 1, dans lequel la détermination de l'état de charge du générateur cible en fonction de la valeur de déséquilibre de puissance comprend :

l'acquisition des résultats de détermination des deux conditions suivantes et la détermination que l'interruption inattendue du générateur cible se produit si les résultats de détermination des deux conditions suivantes sont tous deux Oui ;
condition 1 : déterminer que la valeur de déséquilibre de puissance est supérieure ou non à un seuil d'équilibre de puissance ;
condition 2 : déterminer que le générateur cible passe ou non d'un état de fonctionnement normal à un état basse puissance.

4. Procédé selon la revendication 3, dans lequel la condition 2 comprend :
la détermination que le générateur cible passe ou non de l'état de fonctionnement normal à l'état basse puissance et que le temps durant lequel le générateur cible reste dans l'état basse puissance dépasse ou non un seuil de temps prédéfini.

5. Procédé selon l'une quelconque des revendications 1 à 4, le procédé comprenant en outre, après la détermination de l'état de charge du générateur cible en fonction de la valeur de déséquilibre de puissance :

l'acquisition (301) des résultats de détermination des conditions suivantes et la détermination qu'il convient ou non d'envoyer des informations d'indication en fonction des résultats de détermination acquis, dans lequel les informations d'indication servent à représenter l'interruption de charge inattendue du générateur cible ;
l'interdiction (302) de l'envoi des informations d'indication à un dispositif externe si au moins un des résultats de détermination acquis est Oui ;
condition 3 : déterminer qu'une oscillation de système se produit ou non dans le système où se trouve le générateur cible ;
condition 4 : déterminer que la fonction d'acquisition de signal du générateur cible est anormale ou non ;
condition 5 : déterminer qu'une défaillance se produit ou non au niveau du générateur cible.

6. Procédé selon la revendication 5, dans lequel la condition 5 comprend :
la détermination qu'une tension de séquence négative ou une tension de séquence nulle se produit à l'extrémité de sortie du générateur cible et, si Oui, la détermination qu'une défaillance se produit au niveau du générateur cible.

7. Procédé selon la revendication 5 ou 6, dans lequel la condition 4 comprend :
la détermination qu'une déconnexion se produit ou non au niveau d'au moins un des circuits suivants :

un circuit de mesure de tension et un circuit de mesure de courant, dans lequel le circuit de mesure de tension est utilisé pour déterminer la tension de séquence positive de l'extrémité de sortie du générateur cible, le circuit de mesure de courant est utilisé pour déterminer le courant de séquence positif de l'extrémité de sortie du générateur cible, et la tension de séquence positive et le courant de séquence positif sont utilisés pour déterminer la puissance de charge ;
la détermination que la fonction d'acquisition de signal du générateur cible est anormale si le résultat de la détermination est Oui.

8. Procédé selon l'une quelconque des revendications 5 à 7, le procédé comprenant en outre :
l'envoi des informations d'indication si les résultats de détermination des conditions 3, 4 et 5 sont tous Non.

9. Dispositif de détection d'état de charge de générateur, notamment mis en oeuvre pour entreprendre le procédé selon l'une quelconque des revendications 1 à 8, le dispositif comprenant :

un module d'acquisition de puissance de charge (601), utilisé pour acquérir (101) la puissance de charge d'un générateur cible, dans lequel le générateur cible est connecté à une charge avec un ensemble de câbles, le générateur cible est en mode de régulation de charge et la puissance de charge est utilisée pour représenter la puissance de sortie réelle du générateur cible ;
un module d'acquisition de puissance cible (602), utilisé pour acquérir (102) la puissance de sortie cible du générateur cible, dans lequel la puissance de sortie cible est utilisée pour représenter la puissance requise par le générateur cible afin de produire une sortie en mode de régulation de charge ;
un module de calcul de paramètres (603), utilisé pour calculer (103) la différence entre la puissance de charge acquise par le module d'acquisition de puissance de charge (601) et la puissance de sortie cible acquise par le module d'acquisition de puissance cible (602) en tant que valeur de déséquilibre de puissance ;
**caractérisé par**
un module de détection d'état de charge (604), utilisé pour déterminer (104) qu'une interruption de charge inattendue du générateur cible se produit ou non en fonction de la valeur de déséquilibre de puissance calculée par le module de calcul de paramètres (603).

10. Dispositif selon la revendication 9, dans lequel le module d'acquisition de puissance de charge (601) comprend :

une unité d'acquisition d'informations (6011), utilisée pour acquérir (201) la tension de séquence positive et le courant de séquence positif de l'extrémité de sortie du générateur cible ;
une unité de gestion et de calcul (6012), utilisée pour utiliser la formule suivante afin de calculer (202) la puissance de charge en fonction de la tension de séquence positive et du courant de séquence positif acquis par l'unité d'acquisition d'informations (6011) ;

$$P = 3 \times [Re(U_1).Re(I_1) + Im(U_1).Im(I_1)]$$

dans lequel, $P$ représente la puissance de charge, $U_1$ représente la tension de séquence positive, $I_i$ représente le courant de séquence positif, $Re(U_i)$ représente la partie réelle de la tension de séquence positive, $Im(U_1)$ représente la partie imaginaire de la tension de séquence positive, $Re(I_1)$ représente la partie réelle du courant de séquence positif, et $Im(I_1)$ représente la partie imaginaire du courant de séquence positif.

11. Dispositif selon la revendication 9 ou 10, dans lequel

le module de détection d'état de charge (604) est utilisé pour acquérir les résultats de détermination des deux conditions suivantes et déterminer que l'interruption inattendue du générateur cible se produit si les résultats de détermination des deux conditions suivantes sont tous deux Oui ;
condition 1 : déterminer que la valeur de déséquilibre de puissance est supérieure ou non à un seuil d'équilibre de puissance ;
condition 2 : déterminer que le générateur cible passe ou non d'un état de fonctionnement normal à un état basse puissance.

12. Dispositif selon l'une quelconque des revendications 9 à 11, dans lequel
le module de détection d'état de charge (604) est utilisé pour déterminer que le générateur cible passe ou non de l'état de fonctionnement normal à l'état basse puissance et que le temps durant lequel le générateur cible reste dans l'état de faible puissance dépasse ou non un seuil de temps prédéfini lors de l'acquisition du résultat de détermination de la condition 2.

13. Dispositif selon l'une quelconque des revendications 9 à 12, le dispositif comprenant en outre : un module de détermination de condition (605), utilisé pour acquérir (301) les résultats de détermination des conditions suivantes après que le module de détection d'état de charge (604) a déterminé l'état de charge du générateur cible en fonction de la valeur de déséquilibre de puissance, et déterminer qu'il convient ou non d'envoyer des informations d'indication en fonction des résultats de détermination acquis, dans lequel les informations d'indication sont utilisées pour représenter l'interruption de charge inattendue du générateur cible ;

condition 3 : déterminer qu'une oscillation de système se produit ou non dans le système où se trouve le générateur cible ;
condition 4 : déterminer que la fonction d'acquisition de signal du générateur cible est anormale ou non ;
condition 5 : déterminer qu'une défaillance se produit ou non au niveau du générateur cible.
un module d'interception d'informations (606), utilisé pour interdire (302) au module de détermination d'état (605) d'envoyer les informations d'indication à un dispositif externe si au moins un des résultats de détermination acquis par le module de détermination de condition (605) est Oui ;
le module de détermination de condition (605) étant utilisé pour déterminer qu'une tension de séquence négative ou une tension de séquence nulle se produit ou non à l'extrémité de sortie du générateur cible lors de l'acquisition du résultat de détermination de la condition 5 et, si Oui, déterminer qu'une défaillance se produit au niveau du générateur cible ;
le module de détermination d'état (605) étant utilisé pour déterminer qu'une déconnexion se produit ou non au niveau d'au moins un des circuits suivants : un circuit de mesure de tension et un circuit de mesure de courant lors de l'acquisition du résultat de détermination de la condition 4, et déterminer que la fonction d'acquisition de signal du générateur cible est anormale si le résultat de détermination est Oui, dans lequel le circuit de mesure de tension est utilisé pour déterminer la tension de séquence positive de l'extrémité de sortie du générateur cible, le circuit de mesure de courant est utilisé pour déterminer le courant de séquence positif de l'extrémité de sortie du générateur cible, et la tension de séquence positive et le courant de séquence positif sont utilisés pour déterminer la puissance de charge ;

le module de détermination de condition (605) étant utilisé pour envoyer les informations d'indication lorsque les résultats de détermination acquis des conditions 3, 4 et 5 sont tous Non.

14. Dispositif de détection d'état de charge de générateur, le dispositif comprenant au moins une mémoire (607) et au moins un processeur (608) ;

l'au moins une mémoire (607) étant utilisée pour stocker un programme lisible par machine ; l'au moins un processeur (608) étant utilisé pour appeler le programme lisible par machine afin d'exécuter le procédé selon l'une quelconque des revendications 1 à 8.

15. Support lisible par ordinateur, dans lequel des instructions d'ordinateur sont stockées sur le support lisible par ordinateur et un processeur exécute le procédé selon l'une quelconque des revendications 1 à 8 lorsque les instructions informatiques sont exécutées par le processeur.

Fig. 1

| 201 |
| --- |

| 202 |
| --- |

Fig. 2

Fig. 3

Fig. 4

Fig. 5

Fig. 6

Fig. 7

Fig. 8

Fig. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009159700 A
- DE 102012211719 A1
- EP 2423464 A1